# EUROPÄISCHE PATENTSCHRIFT

(11) **EP 2 346 168 B1**
(45) Veröffentlichungstag und Bekanntmachung des Hinweises auf die Patenterteilung: **16.12.2015**
(21) Anmeldenummer: 10013951.8
(22) Anmeldetag: 26.10.2010
(51) Int. Cl.: H03K 19/0175, H03K 19/017, H03K 17/041, H03K 17/06, H03K 17/687

(54) **Pegelwandlerschaltung**
Level converter circuit
Circuit de décalage de niveau

(30) Priorität: 12.01.2010 DE 102010004488
(43) Veröffentlichungstag der Anmeldung: 20.07.2011
(73) Patentinhaber: Thales Defence Deutschland GmbH, 75175 Pforzheim (DE)
(72) Erfinder: Kaupa, Ehrenhardt, 75177 Pforzheim (DE)
(74) Vertreter: DREISS Patentanwälte PartG mbB

(56) Entgegenhaltungen:
- EP-A1- 0 217 072
- JP-A- 59 095 728
- US-A- 4 390 803

## Beschreibung

Die vorliegende Erfindung betrifft eine Pegelwandlerschaltung, die auch als Levelshift-Schaltung oder Levelshifter bezeichnet wird. Diese umfasst mindestens einen ersten Halbleiterschalter und einen zweiten Halbleiterschalter, wobei Schaltstrecken der beiden Halbleiterschalter in Reihe zueinander angeordnet sind. Eine erste Eingangsspannung liegt an einem ersten Kontakt der Schaltstrecke des ersten Halbleiterschalters an. Zwischen dem Schalteingang und dem ersten Kontakt der Schaltstrecke des ersten Halbleiterschalters ist ein erstes Widerstandselement geschaltet. Ein Ausgangssignal der Pegelwandlerschaltung liegt an einem Ausgang der Pegelwandlerschaltung zwischen einem zweiten Kontakt der Schaltstrecke des ersten Halbleiterschalters und dem ersten Kontakt der Schaltstrecke des zweiten Halbleiterschalters an.

Eine Pegelwandlerschaltung ist bspw. aus der US 4,390,803 bekannt. Pegelwandlerschaltungen werden häufig eingesetzt, um verschiedene Teile einer Schaltung, die mit unterschiedlichen Pegeln kommunizieren, miteinander zu verbinden, z.B. eine TTL-Logik auf der einen Seite und ein RS232-Pegel auf der anderen Seite. Pegelwandlerschaltungen dienen aber auch zur galvanischen Trennung der Schaltungsteile, wenn die Teile auf unterschiedlichen Potentialen arbeiten.

Sehr verbreitet ist auch der Einsatz von Pegelwandlern zum Abstimmen von analogen Signalfiltern. Dabei wird mittels eines Steuersignal relativ niedriger Spannung am Eingang des zweiten Transistors ein höheres Spannungssignal, das am ersten Kontakt der Schaltstrecke des erste Halbleiterschalters anliegt, auf den Ausgang geschaltet. Das Steuersignal beträgt bspw. einige wenige Volt, wohingegen das höhere Spannungssignal einige hundert Volt betragen kann. Das Ausgangssignal wird dann zum Schalten einer PIN (positive intrinsic negative)-Diode genutzt, die in Hochfrequenzschaltungen zum Umschalten von Signalwegen oder Signalfiltern genutzt werden. Ein abstimmbares Signalfilter umfasst mehrere Filterkreise mit PIN-Dioden, bspw. bis zu einigen zehn oder gar hundert Filterkreise. Über eine PIN-Diode kann zum Beispiel ein Filterkreis des Signalfilters durchgeschaltet werden. PIN-Dioden benötigen zum Einschalten einen Steuerstrom der den Serienwiderstand der Dioden bestimmt. PIN-Dioden stellen einen Schalter dar, der gleichermaßen für Hochfrequenzsignale und für hohe Spannungen (im Bereich von einigen hundert oder sogar tausend Volt) geeignet ist. Die Pegelwandlerschaltung stellt die hohen Sperrspannungen und die Steuerströme der PIN-Diode bereit, wobei die Ansteuerung mit üblichen Logikpegeln, zum Beispiel 3,3 Volt CMOS, erfolgt.

Die Firma Pole/Zero Corp., 5530 Union Centre Drive, West Chester, Ohio 45069-4821, USA bietet unter der Bezeichnung "Maxi-Pole" Pegelwandlerschaltungen der eingangs genannte Art an. Dabei dient das zwischen dem Schalteingang und dem ersten Kontakt der Schaltstrecke des ersten Halbleiterschalters geschaltete erste Widerstandselement als Ziehwiderstand (sog. Pull-Up Widerstand), das heißt es dient zum Halten der Schaltstellung des ersten Transistors. Außerdem fließt bei den bekannten Pegelwandlerschaltungen über dieses Widerstandselement der Strom zum Schalten des ersten Halbleiterschalters. Die Schaltgeschwindigkeit der Pegelwandlerschaltung wird also durch den Pull-Up Widerstand bestimmt. In der Regel ist ein schnelles Umschalten der am Ausgang der Pegelwandlerschaltung anliegenden Spannung mit möglichst steilen Signalflanken wünschenswert. Dies ist beispielsweise erforderlich, um in modernen Funksystemen ein Frequenzsprungverfahren (sog. frequency hopping) zu realisieren.

Das kann dadurch erzielt werden, dass der Widerstandswert des Widerstandselements möglichst klein gewählt wird (niederohmiger Ziehwiderstand), und zum Beispiel nur einige Kiloohm groß ist. Das führt allerdings dazu, dass im stationären Zustand der Pegelwandlerschaltung ein Ruhestrom über das Widerstandselement fließt. Insbesondere wenn die erste Spannung relativ hoch ist und beispielsweise im Bereich von einigen hundert Volt liegt, kann dieser Stromfluss erheblich und die am Widerstandselement abfallende statische Verlustleistung groß sein, was zu thermischen Problemen führen kann. Ein niedriger Widerstandswert des Widerstandselements führt also zu einem hohen Energieverbrauch selbst im Ruhezustand und zu einer erheblichen statischen Verlustleistung und damit auch Abwärme am Widerstandselement. Dieser Weg ist deshalb nur eingeschränkt praktikabel, jedenfalls nicht für hohe Spannungen im Bereich von einigen hundert Volt oder darüber.

Eine andere Möglichkeit, ein möglichst schnelles Schalten der Pegelwandlerschaltung zu ermöglichen, die bei den bekannten "Maxi-Pole"-Schaltungen gewählt wurde, besteht darin, den zum schnellen Schalten erforderlichen Strom nicht über den Ziehwiderstand, sondern von einem zusätzlich vorzusehenden Transformator zu beziehen. Dies bedeutet aber, dass theoretisch jeder Pegelwandlerschaltung eines jeden Filterkreises eines abstimmbaren Filters ein eigener Transformator zugeordnet werden müsste. In der Praxis wird jedoch aus Kosten- und Platzgründen nur ein Transformator für alle Pegelwandlerschaltungen der Filterkreise eines Filters vorgesehen. Das hat aber zur Folge, dass bei jedem Schaltvorgang einer bestimmten Pegelwandlerschaltung zunächst alle Filterkreise durchgeschaltet werden müssen, indem alle Pegelwandlerschaltungen auf die höhere Spannung umgeschaltet werden, um dann diejenigen Pegelwandlerschaltungen, die eigentlich nicht geschaltet werden sollen, wieder auf die niedrigere Spannung, zum Beispiel Masse, umzuschalten. Insbesondere beim Frequenzsprungverfahren führt dies zu einem ständigen Hin- und Herschalten der Pegelwandlerschaltungen und zu einem ständigen Aktivieren und Deaktivieren der Filterkreise. Abgesehen von dem mindestens einen zusätzlichen Transformator, der zusätzliche Kosten und einen zusätzlichen Energieverbrauch verursacht, sowie zusätzlichen Bauraum benötigt, ist dabei auch der eigentliche Schaltvorgang der Pegelwandlerschaltungen sehr aufwendig und kompliziert.

Ausgehend von dem beschriebenen Stand der Technik liegt der vorliegenden Erfindung die Aufgabe zugrunde, eine bekannte Pegelwandlerschaltung dahingehend auszugestalten und weiterzubilden, dass sie im stationären Zustand einen möglichst geringen Energieverbrauch hat, sowie ohne großen Aufwand und mit möglichst geringen Kosten realisiert und einfach und schnell umgeschaltet werden kann.

Als eine erste Lösung dieser Aufgabe wird ausgehend von der Pegelwandlerschaltung der eingangs genannten Art vorgeschlagen, dass der zweite Kontakt der Schaltstrecke des ersten Halbleiterschalters und der erste Kontakt der Schaltstrecke des zweiten Halbleiterschalters in einem Kontaktpunkt miteinander in Kontakt stehen, und dass zwischen dem Kontaktpunkt und dem Steuereingang des ersten Halbleiterschalterschalters eine Parallelschaltung eines Kondensators und eines zweiten Schaltelements geschaltet ist, dass eine über ein erstes Schaltelement geschaltete zweite Eingangsspannung, die kleiner als die erste Eingangsspannung ist, an einem nicht an den Kontaktpunkt angeschlossenen Kontakt des Kondensators anliegt und dass zwischen dem nicht an den Kontaktpunkt angeschlossenen Kontakt des Kondensators und dem Steuereingang des ersten Halbleiterschalters ein weiteres Widerstandselement oder eine Schaltstrecke eines dritten Schalters unmittelbar geschaltet ist.

Gemäß einer anderen Lösung der Aufgabe wird ausgehend von der Pegelwandlerschaltung der eingangs genannten Art vorgeschlagen, dass der zweite Kontakt der Schaltstrecke des ersten Halbleiterschalters über einen weiteren Widerstand in einem Kontaktpunkt an dem ersten Kontakt der Schaltstrecke des zweiten Halbleiterschalters mit dem ersten Kontakt der Schaltstrecke des zweiten Halbleiterschalters in Kontakt steht, und dass zwischen dem Kontaktpunkt und dem Steuereingang des ersten Halbleiterschalterschalters eine Parallelschaltung eines Kondensators und eines zweiten Schaltelements geschaltet ist, dass eine über ein erstes Schaltelement geschaltete zweite Eingangsspannung, die kleiner als die erste Eingangsspannung ist, an einem nicht an den Kontaktpunkt angeschlossenen Kontakt des Kondensators anliegt und dass zwischen dem nicht an den Kontaktpunkt angeschlossenen Kontakt des Kondensators und dem Steuereingang des ersten Halbleiterschalters eine Serienschaltung aus einem weiteren Widerstandselement und einer Schaltstrecke eines dritten Schalters unmittelbar geschaltet ist.

Die vorliegende Erfindung schlägt eine Pegelwandlerschaltung mit sehr geringer Treiberleistung und hoher Schaltgeschwindigkeit vor. Die Schaltung wird durch zwei verschiedene Versorgungsspannungen betrieben, nämlich zum einen die relativ hohe erste Spannung, welche die Versorgungsspannung des Pegelschiebers darstellt, und eine niedrigere zweite Spannung, welche im Wesentlichen die Betriebsspannung der Logik-Baugruppen der Schaltung darstellt und auch zum Aufladen des Kondensators dient. Ein bedeutender Aspekt der vorliegenden Erfindung liegt darin, dass die Steuerenergie für den erste Halbleiterschalter zum Hochziehen der am Ausgang anliegenden Spannung auf den hohen Spannungspegel der ersten Eingangsspannung durch einen Kondensator, der aus einer zweiten Eingangsspannungsquelle gespeist wird, zur Verfügung gestellt wird.

Gemäß einer vorteilhaften Weiterbildung der Erfindung sind die Halbleiterschalter als Transistoren, insbesondere als Bipolar- und/oder als Feldeffekttransistoren ausgebildet. Es ist vorgesehen, dass in der Schaltung weitere Widerstandselemente angeordnet sind, bspw. um fließende Ströme zu begrenzen. So ist es bspw. zur Begrenzung des aus dem aufgeladenen Kondensator in den Steuereingang des ersten Halbleiterschalters fließenden Stroms vorgesehen, zwischen dem mit dem ersten Schaltelement in Verbindung stehenden Pol des Kondensators und dem Steuereingang des ersten Halbleiterschalters ein zweites Widerstandselement anzuordnen. Ebenso wäre es denkbar, am Steuereingang des zweiten Halbleiterelements ein drittes Widerstandselement anzuordnen. Statt des zweiten Widerstandselements kann zwischen dem mit dem ersten Schaltelement in Verbindung stehenden Pol des Kondensators und dem Steuereingang des ersten Halbleiterschalters auch ein drittes Schaltelement angeordnet sein. Die Schaltelemente können als Halbleiterschalter, insbesondere als Dioden und/oder Transistoren, ausgebildet sein.

Gemäß einer bevorzugten Ausführungsform der Erfindung wird das Ansteuersignal für den zweiten Halbleiterschalter von einem Rechengerät, insbesondere einem Mikrocontroller generiert und von dort an den Steuereingang angelegt. Das Rechengerät wird von der zweiten Eingangsspannung mit elektrischer Energie versorgt. Über einen Eingang (z.B. I/O-Port) erhält das Rechengerät, bspw. von einem übergeordneten Steuergerät oder einfach von einem mechanischen Schalter, ein Eingangssignal, in dessen Abhängigkeit der zweite Halbleiterschalter angesteuert wird. Vorzugsweise werden auch die Schaltelemente der Pegelwandlerschaltung durch das Rechengerät angesteuert.

Gemäß einer bevorzugten Ausführungsform der Erfindung kann am Ausgang der Pegelwandlerschaltung ein erster Kontakt einer Schaltstrecke eines dritten Halbleiterschalters angeschlossen sein, wobei der zweite Kontakt der Schaltstrecke auf dem Basispotential, bspw. Masse, liegt. Der Steuereingang des dritten Halbleiterschalters ist mit dem Steuereingang des zweiten Halbleiterschalters verbunden. Der dritte Halbleiterschalter wird also zeitgleich mit dem zweiten Halbleiterschalter geschaltet. Im eingeschalteten Zustand, wenn am Ausgang der Pegelwandlerschaltung ein Bezugspotential anliegt, kann über die Schaltstrecke des dritten Halbleiterschalters ein Strom vom Ausgang abfließen, so dass der Spannungsabfall am Ausgang verringert wird.

Schließlich wird gemäß einer anderen bevorzugten Weiterbildung der Erfindung vorgeschlagen, dass die Pegelwandlerschaltung eine Strombegrenzerschaltung aufweist, mit der die Flankensteilheit am Ausgang der Pegelwandlerschaltung eingestellt werden kann. Die Strombegrenzerschaltung umfasst einen weiteren Halbleiterschalter, dessen Schaltstrecke einerseits an dem Steuereingang und andererseits über ein weiteres Widerstandselement an dem zweiten Kontakt der Schaltstrecke des ersten Halbleiterschalters angeschlossen ist. Der Steuereingang des weiteren Halbleiterschalters ist über ein viertes Widerstandselement an den zweiten Kontakt der Schaltstrecke des ersten Halbleiterschalters angeschlossen. Durch Variation der Widerstandswerte des vierten und/oder des weiteren Widerstandselements kann die Flankensteilheit des Ausgangssignals eingestellt werden.

Nachfolgend werden anhand der Figuren verschiedene bevorzugte Ausführungsbeispiele der Erfindung sowie deren Merkmale und Vorteile erläutert. Dabei sind funktionsäquivalente Bauteile mit den gleichen Bezugszeichen bezeichnet. Die einzelnen dargestellten und/oder beschriebenen Bauteile der verschiedenen Ausführungsbeispiele der erfindungsgemäßen Pegelwandlerschaltung haben die angegebenen Merkmale und Vorteile auch ohne die übrigen dargestellten und/oder beschriebenen Bauteile des jeweiligen Ausführungsbeispiels. Es zeigen:
- Figur 1: eine erste bevorzugte Ausführungsform einer erfindungsgemäßen Pegelwandlerschaltung;
- Figur 2: eine zweite bevorzugte Ausführungsform einer erfindungsgemäßen Pegelwandlerschaltung;
- Figur 3: eine dritte bevorzugte Ausführungsform einer erfindungsgemäßen Pegelwandlerschaltung;
- Figur 4: eine vierte bevorzugte Ausführungsform einer erfindungsgemäßen Pegelwandlerschaltung;
- Figur 5: eine aus dem Stand der Technik bekannte erste Form einer Pegelwandlerschaltung; und
- Figur 6: eine aus dem Stand der Technik bekannte zweite Form einer Pegelwandlerschaltung.

Pegelwandlerschaltungen werden in vielen Hochfrequenz (HF)-Schaltungen zum Umschalten von Signalwegen oder analogen Signalfiltern mittels PIN-Dioden eingesetzt. PIN-Dioden benötigen zum Einschalten einen Steuerstrom, der den Serienwiderstand der Dioden bestimmt. Im Sperrzustand wird eine PIN-Diode mit einer hohen Sperrspannung beaufschlagt. Der Betrag dieser Spannung ist von der HF-Leistung und der erforderlichen Linearität der PIN-Diode abhängig.

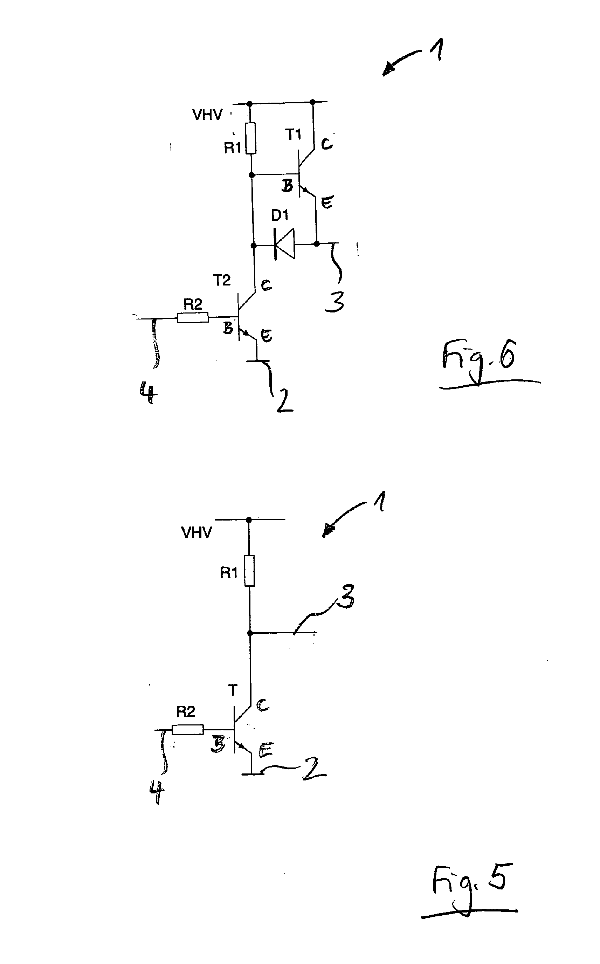

In Figur 5 ist eine erste aus dem Stand der Technik bekannte Pegelwandlerschaltung in ihrer Gesamtheit mit dem Bezugszeichen 1 bezeichnet. Die Schaltung 1 umfasst einen Halbleiterschalter T in Form eines Transistors, insbesondere eines Bipolartransistors. Eine Schaltstrecke des Transistors T zwischen Emitter E und Kollektor C ist einerseits an ein Bezugspotential 2, bspw. Masse, und andererseits über ein erstes Widerstandselement R1 an eine erste Eingangsspannung VHV angeschlossen, wobei der Emitter E an dem Bezugspotential 2 und der Kollektor C an dem Widerstand R1 anliegt. Das Widerstandselement R1 ist relativ hochohmig ausgebildet (Widerstandswert z.B. im Megaohm-Bereich). Zwischen dem Kollektor C des Transistors T und dem Widerstand R1 ist ein Ausgang 3 der Schaltung 1 vorgesehen. Ein Eingangssignal liegt an einem Eingang 4 über ein weiteres Widerstandselement R2 an einem Steuereingang (Basis B) des Transistors T an.

Wenn an dem Eingang 4 der Schaltung 1 aus Figur 5 kein Signal anliegt (z.B. Eingang 4 liegt auf ,low'), sperrt der Transistor T, das heißt die Schaltstrecke CE ist unterbrochen bzw. offen. Am Ausgang 3 liegt die erste Eingangsspannung VHV (,high') an. Wenn jedoch an dem Eingang 4 ein Signal anliegt (z.B. Eingang 4 auf ,high'), schaltet die Schaltstrecke CE durch, der Transistor T wird leitend. Über die Schaltstrecke CE und den ersten Widerstand R1 fließt ein Strom, wobei die Spannung VHV an dem Widerstand R1 abfällt. Am Ausgang 3 liegt ein niedriger Signalpegel (,low') an. Die bekannte Pegelwandlerschaltung ermöglicht zwar ein Umschalten zwischen einem niedrigen Signalpegel und einem hohen Pegel (VHV). Um jedoch hohe Schaltgeschwindigkeiten zu erreichen, muss das erste Widerstandselement R1 relativ niederohmig ausgebildet seim (Widerstandswert z.B. im Kiloohm-Bereich). Das führt jedoch zu einer relativ hohen statischen Verlustleistung.

In Figur 6 ist eine weitere bekannte Pegelwandlerschaltung 1 dargestellt, die auf der Schaltung 1 aus Figur 5 aufbaut. Die Schaltung 1 umfasst zwei Halbleiterschalter T1, T2, die beide als Bipolartransistoren ausgebildet sind. Der Transistor T aus Figur 5 ist in Figur 6 als zweiter Transistor T2 bezeichnet. Zusätzlich ist ein erster Transistor T1 mit seiner Schaltstrecke (Kollektor C, Emitter E) einerseits an der ersten Eingangsspannung VHV und andererseits an einem ersten Kontakt (dem Kollektor C) der Schaltstrecke CE des zweiten Transistors T2 angeschlossen. Der Steuereingang (Basis B) des Transistors T2 ist über den ersten Widerstand R1 an die erste Eingangsspannung VHV und über eine in Sperrrichtung geschaltete Diode D1 an einen zweiten Kontakt (den Emitter E) der Schaltstrecke CE des ersten Transistors T1 und einen ersten Kontakt (den Kollektor )C der Schaltstrecke CE des zweiten Transistors T2 angeschlossen.

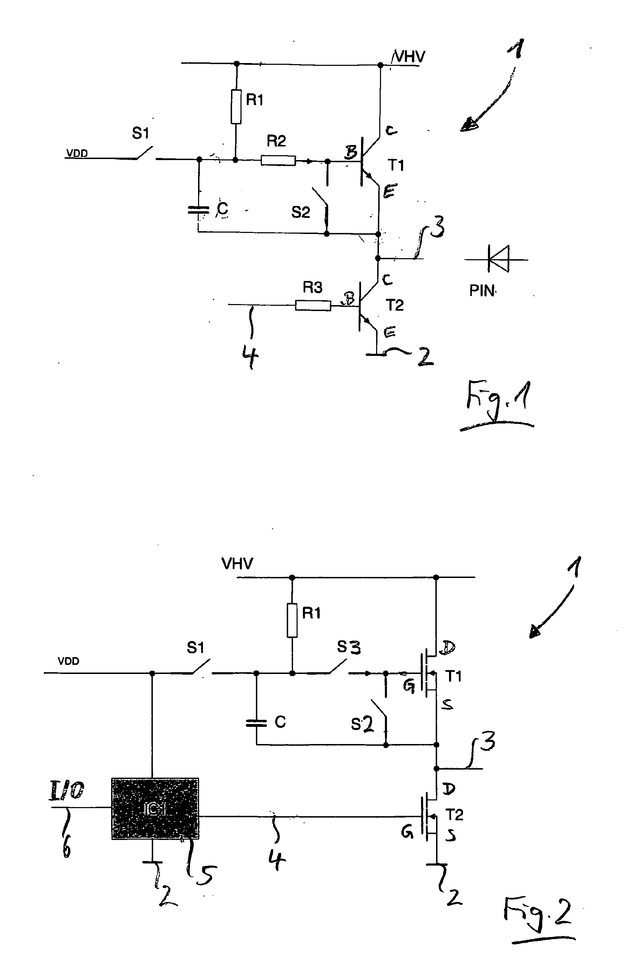

Wenn an dem Eingang 4 der Schaltung 1 aus Figur 6 kein Signal anliegt (z.B. Eingang 4 liegt auf 'low'), sperrt der zweite Transistor T2, das heißt die Schaltstrecke CE ist unterbrochen bzw. offen. Es fließt ein Strom über den ersten Widerstand R1 zum Steuereingang (Basis B) des ersten Halbleiterschalters T1, der durchschaltet. Somit liegt am Ausgang 3 die erste Eingangsspannung VHV (,high') an. Wenn jedoch an dem Eingang 4 ein Signal anliegt (z.B. Eingang 4 auf 'high'), schaltet die Schaltstrecke CE des zweiten Transistors T2 durch, und der Transistor T2 wird leitend. Über seine Schaltstrecke CE und den ersten Widerstand R1 fließt ein Strom, wobei die Spannung VHV an dem Widerstand R1 abfällt. Am Ausgang 3 liegt ein niedriger Signalpegel (,low') an. Auch diese bekannte Pegelwandlerschaltung 1 ermöglicht zwar ein Umschalten zwischen einem niedrigen Signalpegel und einem hohen Pegel (VHV). Um jedoch hohe Schaltgeschwindigkeiten zu erreichen, muss das erste Widerstandselement R1 relativ niederohmig ausgebildet sein (Widerstandswert z.B. im Kiloohm-Bereich). Das führt jedoch auch hier zu einer relativ hohen statischen Verlustleistung. Dies ist bei der erfindungsgemäßen Pegelwandlerschaltung 1, wie sie in verschiedenen Ausführungsbeispielen in den Figuren 1 bis 4 dargestellt ist, anders.

Bei der erfindungsgemäßen Pegelwandlerschaltung 1 aus Figur 1 sind die beiden Halbleiterschalter T1 und T2 als Bipolartransistoren, insbesondere als npn-Bipolartransistoren, ausgebildet. Wenn die erste Eingangsspannung VHV negativ ist, sind die beiden Halbleiterschalter T1 und T2 als pnp-Bipolartransistoren ausgeführt. Es ist eine über ein erstes Schaltelement S1 geschaltete zweite Eingangsspannung VDD, die kleiner als die erste Eingangsspannung VHV ist, vorgesehen. Die niedrigere zweite Spannung VDD ist im Wesentlichen die Betriebsspannung der Logik-Baugruppen, und die höhere erste Spannung VHV ist die hohe Versorgungsspannung des Pegelschiebers. Des Weiteren ist zwischen dem zweiten Kontakt (Emitter E) der Schaltstrecke CE des ersten Halbleiterschalters T1 und dem ersten Kontakt (Kollektor C) der Schaltstrecke CE des zweiten Halbleiterschalters T2 einerseits und dem Steuereingang (Basis B) des ersten Halbleiterschalterschalters T1 andererseits eine Parallelschaltung umfassend einen Kondensator C und ein zweites Schaltelement S2 geschaltet.

Die erfindungsgemäße Pegelwandlerschaltung 1 weist zwei Schaltzustände auf:
Einen ersten Zustand (eingeschalteten Zustand), bei dem ein Bezugspotential 2, zum Beispiel Masse, am Ausgang 3 der Schaltung 1 anliegt. Dazu wird das zweite Schaltelement S2 geschlossen, wodurch der Steuereingang (Basis B) des ersten Halbleiterschalters T1 mit dem zweiten Kontakt (Emitter E) der Schaltstrecke CE des ersten Halbleiterschalters T1 verbunden und der erste Halbleiterschalter T1 gesperrt wird. Anschließend wird der zweite Halbleiterschalter T2 durch ein entsprechendes Signal am Eingang 4 über seinen Steuereingang (Basis B) eingeschaltet, das heißt seine Schaltstrecke CE wird leitend und er zieht die Spannung am Ausgang 3 der Pegelwandlerschaltung 1 gegen das Bezugspotential 2. In dem Ausführungsbeispiel von Figur 1 ist zwischen dem Eingang 4 und dem Steueranschluss (Basis B) des zweiten Halbleiterschalters T2 ein fakultatives drittes Widerstandselement R3 angeordnet. Der mit dem zweiten Kontakt (Emitter E) der Schaltstrecke CE des ersten Halbleiterschalters T1 verbundene Pol des Kondensators C wird somit auch auf das Bezugspotential 2 gezogen. Gleichzeitig oder anschließend wird das erste Schaltelement S1 geschlossen und dadurch der andere, in dem dargestellten Ausführungsbeispiel über ein fakultatives zweites Widerstandselement R2 an den Steuereingang (Basis B) des ersten Halbleiterschalters T1 angeschlossene Pol des Kondensators C mit der zweiten Eingangspannung VDD verbunden. Der Kondensator C wird innerhalb kurzer Zeit (vorzugsweise im Mikrosekundenbereich) auf die anliegende Eingangsspannung VDD aufgeladen. Über eine am Ausgang 3 der Schaltung 1 beispielsweise angeschlossene PIN-Diode PIN fließt ein Strom, so dass die PIN-Diode PIN einen relativ niedrigen Serienwiderstand aufweist. In diesem Zustand ist der statische Stromverbrauch an der hohen ersten Eingangsspannung VHV niedrig, da der erste Halbleiterschalter T1 gesperrt ist, und das zwischen dem Schalteingang (Basis B) und dem ersten Kontakt (Kollektor C) der Schaltstrecke CE des ersten Halbleiterschalters T1 angeordnete erste Widerstandselement R1 kann hochohmig (vorzugsweise im Megaohm-Bereich) ausgelegt werden. Die statische Verlustleistung wird somit minimiert.

Einen zweiten Zustand (ausgeschalteten Zustand), bei dem die hohe erste Eingangsspannung VHV am Ausgang 3 der Schaltung 1 anliegt. Der zweite Halbleiterschalter T2 wird durch ein entsprechendes Signal am Eingang 4 über den Steuereingang (Basis B) ausgeschaltet. Anschließend werden das erste Schaltelement S1 und das zweite Schaltelement S2 geöffnet. Die in dem Kondensator C gespeicherte Ladung fließt nun sehr schnell in den Steuereingang (Basis B) des ersten Halbleiterschalters T1. Das zwischen dem Kondensator C und dem Steuereingang (Basis B) angeordnete zweite Widerstandselement R2 dient zur Begrenzung des in den Steuereingang fließenden Stroms. Der erste Halbleiterschalter T1 wird somit schlagartig in einen niederohmigen Zustand geschaltet und sorgt dafür, dass die Spannung am Ausgang 3 der Pegelwandlerschaltung 1 schnell auf die hohe erste Eingangsspannung VHV ansteigt. Anschließend reicht der kleine Basisstrom über das erste Widerstandselement R1 aus, um den ersten Halbleiterschalter T1 im leitenden Zustand zu halten. Die Steuerenergie für den ersten Halbleiterschalter T1 zum Hochziehen des Ausgangs 3 auf einen hohen Spannungspegel VHV ist also in dem Kondensator C gespeichert, der aus der zweiten Spannungsquelle VDD gespeist wird, und wird bei Bedarf durch Entladen des Kondensators C schnell zur Verfügung gestellt. Auf diese Weise kann auf einfache und kostengünstige Weise trotz eines hochohmigen ersten Widerstandselements R1 ein schnelles Schalten der Schaltung 1 erreicht werden.

Bei dem Ausführungsbeispiel aus Figur 2 sind die Halbleiterschalter T1 und T2 als Feldeffekttransistoren (FETs), insbesondere als MOSFETs (Metal Oxide Semiconductor FETs), besonders bevorzugt als n-Kanal MISFETs (Metal Insulator Semiconductor FETs) oder auch als IGFETs (Insulated Gate FETs) vom Anreicherungstyp, ausgebildet. Es kommen insgesamt drei Schaltelemente S1, S2, S3 zum Einsatz, mit deren Hilfe die Ladung am Kondensator C direkt an den Steuereingang (Gate G) des ersten Halbleiterschalters T1 umgeschaltet wird. Diese sehr niederohmige Ansteuerung der Gate-Spannung bewirkt eine sehr steile Anstiegsflanke am Schalterausgang 3. Außerdem ist der statische Strom im High-Zustand (erster Halbleiterschalter T1 offen bzw. gesperrt) gering, da die MOSFETs T1 und T2 (bis auf geringe Leckströme) stromlos angesteuert werden.

Außerdem ist in Figur 2 ein Rechengerät 5 eingezeichnet, das von der niedrigen zweiten Eingangsspannung VDD mit Energie versorgt wird. Das Rechengerät ist beispielsweise als ein Mikrocontroller oder ein Logikgatter ausgebildet. Über einen Eingang (I/O) 6 erhält der Mikrocontroller 5 einen Steuerbefehl. Dieser kann von einem übergeordneten Steuergerät (nicht dargestellt), von einem mechanischem Schalter (nicht dargestellt) oder ähnlichem kommen. Abhängig von dem Steuerbefehl generiert der Mikrocontroller 5 ein Steuersignal für den zweiten Halbleiterschalter T2. Auf diese Weise kann der Ausgang 3 der Schaltung 1 zwischen einem niedrigen Potential (bspw. dem Bezugspotential 2) und einem hohen Potential (bspw. der hohen ersten Spannung VHV) umgeschaltet werden. Dadurch wird zum Beispiel die am Ausgang 3 angeschlossene PIN-Diode ein- und ausgeschaltet, so dass bspw. ein mittels der PIN-Diode geschalteter Filterkreis zu- oder abgeschaltet werden kann. Dadurch ist es bspw. möglich, ein analoges Signalfilter abzustimmen oder ein sog. Frequency-Hopping eines Funkgeräts, in dem das Signalfilter enthalten ist, zu realisieren.

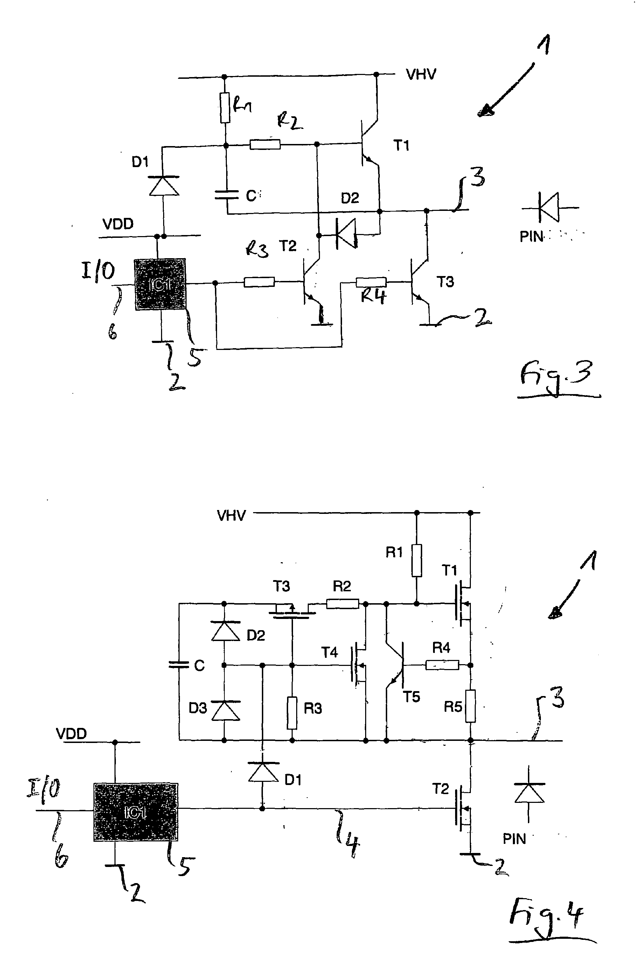

Bei dem Ausführungsbeispiel aus Figur 3 sind die beiden Halbleiterschalter T1 und T2 wiederum als Bipolartransistoren, insbesondere als npn-Bipolartransistoren, ausgebildet. Die beiden Schaltelemente S1 und S2 aus Figur 1 wurden durch eine Diode D1 und den zweiten Halbleiterschalter T2 ersetzt. Außerdem ist ein zusätzlicher Schaltungsteil vorgesehen. Dieser umfasst einen dritten Halbleiterschalter T3, der in dem Beispiel als ein Bipolartransistor, insbesondere als ein npn-Bipolartransistor ausgebildet ist. Der Halbleiterschalter T3 überbrückt eine Diode D2 und den zweiten Halbleiterschalter T2 im eingeschalteten (geschlossenen) Zustand (Ausgang 3 liegt auf dem Bezugspotential 2) und verringert dadurch den Spannungsabfall an der Serienschaltung aus Diode D2 und Halbleiterschalter T2. Der dritte Halbleiterschalter T3 wird gleichzeitig mit dem zweiten Halbleiterschalter T2 von dem Rechengerät 5 über ein viertes Widerstandselement R4 angesteuert. Bei bestimmten Anwendungen kann die zusätzliche Schaltung T3, R4 auch entfallen, ohne dass die Funktion der Schaltung 1 beeinträchtigt würde.

In dem Ausführungsbeispiel aus Figur 4 sind die beiden Halbleiterschalter T1 und T2 wiederum als FETs ausgebildet. Darüber hinaus umfasst die Schaltung 1 aber auch noch weitere Halbleiterschalter T3, T4, T5, die als FETs oder als Bipolartransistoren ausgebildet sein können. Die Schalter S2 und S3 aus Figur 2 wurden in Figur 4 durch die Halbleiterschalter T3 und T4 (S2 durch T4 und S3 durch T3) realisiert, die beide als FETs ausgebildet sind. Die Transistoren T3 und T4 werden über zusätzlich vorgesehene Dioden D2 und D3 angesteuert. Der Schalter S1 ist durch die Diode D1 realisiert. Zusätzlich beinhaltet die Schaltung 1 aus Figur 4 eine Strombegrenzerschaltung umfassend einen fünften Halbleiterschalter T5, der als ein Bipolartransistor ausgebildet ist, sowie zwei zusätzliche Widerstände R4 und R5. Über die Schaltung T5, R4, R5 kann die Steilheit der Flanken des am Ausgang 3 anliegenden Spannungssignals eingestellt werden.

Die erste Eingangsspannung VHV ist größer als die zweite Eingangsspannung VDD. Die Spannung VHV kann sogar einige hundert Volt, z.B. 300 bis 500 Volt betragen. Die zweite Eingangsspannung VDD kann bspw. 3 bis 5 Volt betragen. Das reicht zum Aufladen des Kondensators C, damit dieser die Steuerenergie für den Halbleiterschalter T1 zur Verfügung stellen kann, aus. Die Widerstandselemente R1, ..., R5 sind vorzugsweise als ohmsche Widerstände ausgebildet. Es wäre theoretisch denkbar, dass die Widerstandselemente R1, ..., R5 auch auf andere Weise, bspw. als kapazitive oder induktive Widerstände, oder auf andere Weise realisiert sind. Der Wert des zwischen der ersten Spannung VHV und dem Steuereingang (Basis B bzw. Gate G) des ersten Halbleiterschalters T1 geschalteten ersten Widerstandselements R1 liegt vorzugsweise im Megaohmbereich, mit dem Ziel die statische Verlustenergie möglichst gering zu halten.

## Patentansprüche

1. Pegelwandlerschaltung (1) umfassend mindestens einen ersten Halbleiterschalter (T1) und einen zweiten Halbleiterschalter (T2), wobei Schaltstrecken (CE; DS) der Halbleiterschalter (T1, T2) in Reihe zueinander angeordnet sind, eine erste Eingangsspannung (VHV) an einem ersten Kontakt (C; D) der Schaltstrecke (CE; DS) des ersten Halbleiterschalters (T1) anliegt, zwischen einem Schalteingang (B; G) und dem ersten Kontakt (C; D) der Schaltstrecke (CE; DS) des ersten Halbleiterschalters (T1) ein erstes Widerstandselement (R1) geschaltet ist, und an einem Ausgang (3) der Pegelwandlerschaltung (1) zwischen einem zweiten Kontakt (E; S) der Schaltstrecke (CE; DS) des ersten Halbleiterschalters (T1) und dem ersten Kontakt (C; D) der Schaltstrecke (CE; DS) des zweiten Halbleiterschalters (T2) ein Ausgangssignal anliegt, wobei der zweite Kontakt (E; S) der Schaltstrecke (CE; DS) des ersten Halbleiterschalters (T1) und der erste Kontakt (C; D) der Schaltstrecke (CE; DS) des zweiten Halbleiterschalters (T2) in einem Kontaktpunkt miteinander in Kontakt stehen, und wobei zwischen dem Kontaktpunkt und dem Steuereingang (B; G) des ersten Halbleiterschalterschalters (T1) eine Parallelschaltung eines Kondensators (C) und eines zweiten Schaltelements (S2; T4) geschaltet ist, dass eine über ein erstes Schaltelement (S1; D1) geschaltete zweite Eingangsspannung (VDD), die kleiner als die erste Eingangsspannung (VHV) ist, an einem nicht an den Kontaktpunkt angeschlossenen Kontakt des Kondensators (C) anliegt, **dadurch gekennzeichnet, dass** zwischen dem nicht an den Kontaktpunkt angeschlossenen Kontakt des Kondensators (C) und dem Steuereingang (B; G) des ersten Halbleiterschalters (T1) ein weiteres Widerstandselement (R2) oder eine Schaltstrecke eines dritten Schalters (S3) unmittelbar geschaltet ist.

2. Pegelwandlerschaltung (1) umfassend mindestens einen ersten Halbleiterschalter (T1) und einen zweiten Halbleiterschalter (T2), wobei Schaltstrecken (CE; DS) der Halbleiterschalter (T1, T2) in Reihe zueinander angeordnet sind, eine erste Eingangsspannung (VHV) an einem ersten Kontakt (C; D) der Schaltstrecke (CE; DS) des ersten Halbleiterschalters (T1) anliegt, zwischen einem Schalteingang (B; G) und dem ersten Kontakt (C; D) der Schaltstrecke (CE; DS) des ersten Halbleiterschalters (T1) ein erstes Widerstandselement (R1) geschaltet ist, und an einem Ausgang (3) der Pegelwandlerschaltung (1) zwischen einem zweiten Kontakt (E; S) der Schaltstrecke (CE; DS) des ersten Halbleiterschalters (T1) und dem ersten Kontakt (C; D) der Schaltstrecke (CE; DS) des zweiten Halbleiterschalters (T2) ein Ausgangssignal anliegt, **dadurch gekennzeichnet, dass** der zweite Kontakt (E; S) der Schaltstrecke (CE; DS) des ersten Halbleiterschalters (T1) über einen weiteren Widerstand (R5) in einem Kontaktpunkt an dem ersten Kontakt der Schaltstrecke des zweiten Halbleiterschalters mit dem ersten Kontakt (C; D) der Schaltstrecke (CE; DS) des zweiten Halbleiterschalters (T2) in Kontakt steht, und dass zwischen dem Kontaktpunkt und dem Steuereingang (B; G) des ersten Halbleiterschalterschalters (T1) eine Parallelschaltung eines Kondensators (C) und eines zweiten Schaltelements (T4) geschaltet ist, dass eine über ein erstes Schaltelement (D1) geschaltete zweite Eingangsspannung (VDD), die kleiner als die erste Eingangsspannung (VHV) ist, an einem nicht an den Kontaktpunkt angeschlossenen Kontakt des Kondensators (C) anliegt und dass zwischen dem nicht an den Kontaktpunkt angeschlossenen Kontakt des Kondensators (C) und dem Steuereingang (B; G) des ersten Halbleiterschalters (T1) eine Serienschaltung eines weiteren Widerstandselements (R2) und einer Schaltstrecke eines dritten Schalters (T3) unmittelbar geschaltet ist.

3. Pegelwandlerschaltung (1) nach Anspruch 1 oder 2, **dadurch gekennzeichnet, dass** die Pegelwandlerschaltung (1) ein Rechengerät (5), insbesondere einen Mikrocontroller oder ein Logikgatter, aufweist, das ein Steuersignal ausgibt, das an dem Steuereingang (B; G) des zweiten Halbleiterschalters (T2) anliegt.

4. Pegelwandlerschaltung (1) nach Anspruch 3, **dadurch gekennzeichnet, dass** das Rechengerät (5) an der zweiten Eingangsspannung (VDD) als Versorgungsspannung anliegt.

5. Pegelwandlerschaltung (1) nach Anspruch 3 oder 4, **dadurch gekennzeichnet, dass** das Rechengerät, (5) zumindest eines der Schaltelemente (S1, S2, D1, T4) ansteuert.

6. Pegelwandlerschaltung (1) nach einem der Ansprüche 1 bis 5, **dadurch gekennzeichnet, dass** ein Schließen des ersten und des zweiten Schaltelements (S1; D1; S2; T4) ein Aufladen des Kondensators (C) durch die zweiten Eingangsspannung (VDD) bewirkt.

7. Pegelwandlerschaltung (1) nach Anspruch 6, **dadurch gekennzeichnet, dass** ein Öffnen des ersten und des zweiten Schaltelements (S1; D1; S2; T4) bei aufgeladenem Kondensator (C) ein Entladen des Kondensators (C) über den Steuereingang (B; G) des ersten Halbleiterschalters (T1) bewirkt.

8. Pegelwandlerschaltung (1) nach einem der Ansprüche 1 bis 7, **dadurch gekennzeichnet, dass** das erste Widerstandselement (R1) sehr hochohmig, insbesondere im Megaohm-Bereich, ausgebildet ist.

9. Pegelwandlerschaltung (1) nach einem der Ansprüche 1 bis 8, **dadurch gekennzeichnet, dass** zumindest einer der Halbleiterschalter (T1; T2) als Transistor ausgebildet ist.

10. Pegelwandlerschaltung (1) nach Anspruch 9, **dadurch gekennzeichnet, dass** zumindest einer der Halbleiterschalter (T1; T2) als Bipolartransistor ausgebildet ist.

11. Pegelwandlerschaltung (1) nach Anspruch 9, **dadurch gekennzeichnet, dass** die Halbleiterschalter (T1, T2) als Feldeffekttransistoren ausgebildet sind.

12. Pegelwandlerschaltung (1) nach einem der Ansprüche 1 bis 11, **dadurch gekennzeichnet, dass** zumindest eines der Schaltelemente (S1) als Diode (D1) ausgebildet ist.

13. Pegelwandlerschaltung (1) nach einem der Ansprüche 1 bis 12, **dadurch gekennzeichnet, dass** zumindest eines der Schaltelemente (S2) als ein Transistor (T4), insbesondere als ein Feldeffekttransistor, ausgebildet ist.

## Claims

1. A level converter circuit (1), including at least one first semiconductor switch (T1) and one second semiconductor switch (T2), in which contact gaps (CE; DS) of the semiconductor switches (T1, T2) are located in series with one another, a first input voltage (VHV) is applied to a first contact (C; D) of the contact gap (CE; DS) of the first semiconductor switch (T1), a first resistor element (R1) is connected between a circuit input (B; G) and the first contact (C; D) of the contact gap (CE; DS) of the first semiconductor switch (T1), and an output signal is applied to an output (3) of the level converter circuit (1) between a second contact (E; S) of the contact gap (CE; DS) of the first semiconductor switch (T1) and the first contact (C; D) of the contact gap (CE; DS) of the second semiconductor switch (T2), and the second contact (E; S) of the contact gap (CE; DS) of the first semiconductor switch (T1) and the first contact (C; D) of the contact gap (CE; DS) of the second semiconductor switch (T2) are in contact with one another at a contact point, and a parallel circuit of a capacitor (C) and a second switch element (S2; T4) is connected between the contact point and the control input (B; G) of the first semiconductor switch (T1), and that a second input voltage (VDD), which is less than the first input voltage (VHV) and is connected via a first switch element (S1; D1), is applied to a contact, not connected to the contact point, of the capacitor (C), **characterized in that** a further resistor element (R2) or a contact gap of a third switch (S3) is directly connected between the contact, not connected to the contact point, of the capacitor (C) and the control input (B; G) of the first semiconductor switch (T1).

2. A level converter circuit (1), including at least one first semiconductor switch (T1) and one second semiconductor switch (T2), in which contact gaps (CE; DS) of the semiconductor switches (T1, T2) are located in series with one another, a first input voltage (VHV) is applied to a first contact (C; D) of the contact gap (CE; DS) of the first semiconductor switch (T1), a first resistor element (R1) is connected between a circuit input (B; G) and the first contact (C; D) of the contact gap (CE; DS) of the first semiconductor switch (T1), and an output signal is applied to an output (3) of the level converter circuit (1) between a second contact (E; S) of the contact gap (CE; DS) of the first semiconductor switch (T1) and the first contact (C; D) of the contact gap (CE; DS) of the second semiconductor switch (T2), **characterized in that** the second contact (E; S) of the contact gap (CE; DS) of the first semiconductor switch (T1) is in contact, via a further resistor (R5) at a contact point at the first contact of the contact gap of the second semiconductor switch, with the first contact (C; D) of the contact gap (CE; DS) of the second semiconductor switch (T2) at a contact point; and that a parallel circuit of a capacitor (C) and a second switch element T4) is connected between the contact point and the control input (B; G) of the first semiconductor switch (T1); that a second input voltage (VDD), which is less than the first input voltage (VHV) and is connected via a first switch element D1), is applied to a contact, not connected to the contact point, of the capacitor (C); and that a series circuit of a further resistor element (R2) and a contact gap of a third switch (T3) is directly connected between the contact, not connected to the contact point, of the capacitor (C) and the control input (B; G) of the first semiconductor switch (T1).

3. The level converter circuit (1) of claim 1 or 2, **characterized in that** the level converter circuit (1) has a computer (5), in particular a microcontroller or a logic gate, which outputs a control signal that is applied to the control input (B; G) of the second semiconductor switch (T2).

4. The level converter circuit (1) of claim 3, **characterized in that** the computer (5) is connected to the second input voltage (VDD), as a supply voltage.

5. The level converter circuit (1) of claim 3 or 4, **characterized in that** the computer (5) triggers at least one of the switch elements (S1, S2, D1, T4).

6. The level converter circuit (1) of one of claims 1 through 5, **characterized in that** a closure of the first and second switch elements (S1; D2; S2; T4) effects a charging of the capacitor (C) by the second input voltage (VDD).

7. The level converter circuit (1) of claim 6, **characterized in that** an opening of the first and second switch elements (S1; D1; S2; T4) with a charged capacitor (C) effects a discharging of the capacitor (C) via the control input (B; G) of the first semiconductor switch (T1).

8. The level converter circuit (1) of one of claims 1 through 7, **characterized in that** the first resistor element (R1) is embodied with very high impedance, in particular in the megaohm range.

9. The level converter circuit (1) of one of claims 1 through 8, **characterized in that** at least one of the semiconductor switches (T1; T2) is embodied as a transistor.

10. The level converter circuit (1) of claim 9, **characterized in that** at least one off the semiconductor switches (T1; T2) is embodied as a bipolar transistor.

11. The level converter circuit (1) of claim 9, **characterized in that** the semiconductor switches (T1, T2) are embodied as field effect transistors.

12. The level converter circuit (1) of one of claims 1 through 11, **characterized in that** at least one of the switch elements (S1) is embodied as a diode (D1).

13. The level converter circuit (1) of one of claims 1 through 12, **characterized in that** at least one of the switch elements (S2) is embodied as a transistor (T4), in particular as a field effect transistor.

## Revendications

1. Circuit convertisseur de niveau (1) comprenant au moins un premier commutateur semi-conducteur (T1) et un deuxième commutateur semi-conducteur (T2), des trajets de commutation (CE; DS) des commutateurs semi-conducteurs (T1, T2) étant disposés en série l'un par rapport à l'autre, une première tension d'entrée (VHV) étant appliquée à un premier contact (C; D) du trajet de commutation (CE; DS) du premier commutateur semi-conducteur (T1), un premier élément de résistance (R1) étant monté entre une entrée de commutation (B; G) et le premier contact (C; D) du trajet de commutation (CE; DS) du premier commutateur semi-conducteur (T1), et un signal de sortie étant appliqué à une sortie (3) du circuit convertisseur de niveau (1) entre un deuxième contact (E; S) du trajet de commutation (CE; DS) du premier commutateur semi-conducteur (T1) et le premier contact (C; D) du trajet de commutation (CE; DS) du deuxième commutateur semi-conducteur (T2), dans lequel ledit deuxième contact (E; S) du trajet de commutation (CE; DS) du premier commutateur semi-conducteur (T1) et le premier contact (C; D) du trajet de commutation (CE; DS) du deuxième commutateur semi-conducteur (T2) sont en contact entre eux sur un point de contact, et dans lequel, entre ledit point de contact et l'entrée de commande (B; G) du premier commutateur semi-conducteur (T1), est monté un montage en parallèle d'un condensateur (C) et d'un deuxième élément de commutation (S2; T4), dans lequel une deuxième tension d'entrée (VDD) qui est commutée via un premier élément de commutation (S1; D1) et qui est inférieure à la première tension d'entrée (VHV) est appliquée à un contact du condensateur (C), qui n'est pas connecté au point de contact, **caractérisé par le fait qu'**un autre élément de résistance (R2) ou un trajet de commutation d'un troisième commutateur (S3) est monté directement entre le contact du condensateur (C), qui n'est pas connecté au point de contact, et l'entrée de commande (B; G) du premier commutateur semi-conducteur (T1).

2. Circuit convertisseur de niveau (1) comprenant au moins un premier commutateur semi-conducteur (T1) et un deuxième commutateur semi-conducteur (T2), des trajets de commutation (CE; DS) des commutateurs semi-conducteurs (T1, T2) étant disposés en série l'un par rapport à l'autre, une première tension d'entrée (VHV) étant appliquée à un premier contact (C; D) du trajet de commutation (CE; DS) du premier commutateur semi-conducteur (T1), un premier élément de résistance (R1) étant monté entre une entrée de commutation (B; G) et le premier contact (C; D) du trajet de commutation (CE; DS) du premier commutateur semi-conducteur (T1), et un signal de sortie étant appliqué à une sortie (3) du circuit convertisseur de niveau (1) entre un deuxième contact (E; S) du trajet de commutation (CE; DS) du premier commutateur semi-conducteur (T1) et le premier contact (C; D) du trajet de commutation (CE; DS) du deuxième commutateur semi-conducteur (T2), **caractérisé par le fait que** ledit deuxième contact (E; S) du trajet de commutation (CE; DS) du premier commutateur semi-conducteur (T1) est en contact avec le premier contact (C; D) du trajet de commutation (CE; DS) du deuxième commutateur semi-conducteur (T2), par une autre résistance (R5) sur un point de contact, sur le premier contact du trajet de commutation du deuxième commutateur semi-conducteur, et que, entre ledit point de contact et l'entrée de commande (B; G) du premier commutateur semi-conducteur (T1), est monté un montage en parallèle d'un condensateur (C) et d'un deuxième élément de commutation (T4), qu' une deuxième tension d'entrée (VDD) qui est commutée via un premier élément de commutation (D1) et qui est inférieure à la première tension d'entrée (VHV) est appliquée à un contact du condensateur (C), qui n'est pas connecté au point de contact, et qu'un montage en série d'un autre élément de résistance (R2) et d'un trajet de commutation d'un troisième commutateur (T3) est monté directement entre le contact du condensateur (C), qui n'est pas connecté au point de contact, et l'entrée de commande (B; G) du premier commutateur semi-conducteur (T1).

3. Circuit convertisseur de niveau (1) selon la revendication 1 ou 2, **caractérisé par le fait que** le circuit convertisseur de niveau (1) présente un dispositif de calcul (5), en particulier un microcontrôleur ou une porte logique, qui délivre en sortie un signal de commande qui est appliqué à l'entrée de commande (B; G) du deuxième commutateur semi-conducteur (T2).

4. Circuit convertisseur de niveau (1) selon la revendication 3, **caractérisé par le fait que** le dispositif de calcul (5) est appliqué à la deuxième tension d'entrée (VDD) en tant que tension d'alimentation.

5. Circuit convertisseur de niveau (1) selon la revendication 3 ou 4, **caractérisé par le fait que** ledit dispositif de calcul (5) commande au moins l'un des éléments de commutation (S1, S2, D1, T4).

6. Circuit convertisseur de niveau (1) selon l'une quelconque des revendications 1 à 5, **caractérisé par le fait qu'**une fermeture des premier et deuxième éléments de commutation (S1; D1; S2; T4) provoque un chargement du condensateur (C) par la deuxième tension d'entrée (VDD).

7. Circuit convertisseur de niveau (1) selon la revendication 6, **caractérisé par le fait qu'**une ouverture des premier et deuxième éléments de commutation (S1; D1; S2; T4), lorsque le condensateur (C) est chargé, provoque une décharge du condensateur (C) via l'entrée de commande (B; G) du premier commutateur semi-conducteur (T1).

8. Circuit convertisseur de niveau (1) selon l'une quelconque des revendications 1 à 7, **caractérisé par le fait que** le premier élément de résistance (R1) est réalisé de manière à être de valeur ohmique très élevée, en particulier dans la plage du méga-ohm.

9. Circuit convertisseur de niveau (1) selon l'une quelconque des revendications 1 à 8, **caractérisé par le fait que** l'un au moins des commutateurs semi-conducteurs (T1; T2) est réalisé comme transistor.

10. Circuit convertisseur de niveau (1) selon la revendication 9, **caractérisé par le fait que** l'un au moins des commutateurs semi-conducteurs (T1; T2) est réalisé comme transistor bipolaire.

11. Circuit convertisseur de niveau (1) selon la revendication 9, **caractérisé par le fait que** les commutateurs semi-conducteurs (T1; T2) sont réalisés comme transistors à effet de champ.

12. Circuit convertisseur de niveau (1) selon l'une quelconque des revendications 1 à 11, **caractérisé par le fait que** l'un au moins des éléments de commutation (S1) est réalisé en tant que diode (D1).

13. Circuit convertisseur de niveau (1) selon l'une quelconque des revendications 1 à 12, **caractérisé par le fait que** l'un au moins des éléments de commutation (S2) est réalisé comme un transistor (T4), en particulier comme un transistor à effet de champ.
